# EUROPEAN PATENT SPECIFICATION

(11) **EP 2 665 185 B1**
(45) Date of publication and mention of the grant of the patent: **17.08.2016**
(21) Application number: 13000456.7
(22) Date of filing: 30.01.2013
(51) Int. Cl.: H03K 7/08, H03K 3/017

(54) **Pulse width modulation circuit and pulse width modulation signal generating method having two fresh rates**
Impulsbreitenmodulationsschaltung und Verfahren zur Erzeugung eines Impulsbreitenmodulationssignals mit zwei frischen Raten
Circuit de modulation de largeur d'impulsions et procédé de génération de signal de modulation de largeur d'impulsions possédant deux débits actualisés

(30) Priority: 16.05.2012 TW 101117350
(43) Date of publication of application: 20.11.2013
(73) Proprietor: Silicon Touch Technology Inc., Hsin-Chu (TW)
(72) Inventor: Chin, Chi-Yuan, Taipei City (TW); Chen, Kuei-Jyun, Taoyuan County (TW)
(74) Representative: Hoefer & Partner Patentanwälte mbB

(56) References cited:
- EP-A2- 2 048 648
- US-A1- 2003 214 242
- US-A1- 2007 212 078
- WON-SIK OH ET AL: "A Novel Two-Dimensional Adaptive Dimming Technique of X-Y Channel Drivers for LED Backlight System in LCD TVs", JOURNAL OF DISPLAY TECHNOLOGY, IEEE SERVICE CENTER, NEW YORK, NY, US, vol. 5, no. 1, 1 January 2009 (2009-01-01) , pages 20-26, XP011252823, ISSN: 1551-319X

## Description

The present invention relates to a pulse width modulation, hereinafter PWM, circuit and a PWM signal generation method having two fresh rates according to the pre-characterizing clauses of claims 1 and 7.

In electronic apparatuses, a PWM signal is usually utilized as a control signal. For example, the duty cycle of a PWM signal might be adjusted to control the brightness of video frames or the charging/discharging of a voltage conversion circuit. For the conventional PWM circuit, when the PWM signal is used to control the brightness of video frames, the cycle means the refresh rate. That is to say, the PWM signal with the short cycle has a higher refresh rate, and the PWM signal with the longer cycle has a lower refresh rate in contrary; however, the resolution, which is another important characteristic, is inversely proportional to the refresh rate.

Generally speaking, only a single PWM signal of a single dimension (i.e., a single direction) is used in the current control mechanism of the PWM signal. Therefore, there is a dilemma between the resolution and the refresh rate, thereby limiting the design of the PWM circuit.

Related document WON-SIK OH ET AL: "A novel Two-Dimensional Adaptive Dimming Technique of X-Y Channel Drivers for LED Backlight System in LCD TVs", JOURNAL OF DISPLAY TECHNOLOGY, IEEE SERVICE CENTER, NEW YORK, NY, US, discloses: In this paper, a novel two dimensional (2-D) adaptive dimming technique with X-Y channels for light-emitting diode (LED) backlight system in LCD TVs is proposed. The proposed LED backlight has matrix-structured LED modules with row and column switches to control the brightness of individual division block. It shows local dimming effects such as reduced power consumption and high dynamic contrast ratio even with much less number of LED drivers than that of the conventional 2-D local dimming method.

Related document US2007212078 A1 discloses: A signal transmission method in which a transmitter generates a data signal by multiplexing a plurality of pieces of data and transmits the generated data signal to a receiver through a transmission channel and in which the receiver generates a plurality of pulse-width modulation signals corresponding to the plurality of pieces of data in accordance with the data signal includes generating, by means of the transmitter. The data signal in accordance with the plurality of pieces of data such that, at the beginning of each of a plurality of sections of the corresponding pulse-width modulation signals for which logical levels of the corresponding pulse-width modulation signals are set, the logical level of the data signal corresponds to the logical level of the corresponding pulse-width modulation signal for the corresponding section, wherein a transition between the plurality of sections is performed at a different timing for each of the plurality of pulse-width modulation signals; and generating, by means of the receiver, in each of a plurality of systems for generating the corresponding pulse-width modulation signals, the corresponding pulse-width modulation signal by latching the data signal at the beginning of the corresponding section for the corresponding system and holding the data signal until the beginning of the next section for the corresponding system.

Related document EP2048648A2 discloses a liquid crystal display device including an LED array unit including a plurality of LED arrays, the LED array unit emitting a light; an LED driving unit supplying at least two PWM signals to the LED array unit, the at least two PWM signals having different phases from each other; a liquid crystal display panel displaying images using the light from the LED array unit; a gate driving unit supplying a gate signal to the liquid crystal display panel; a data driving unit supplying a data signal to the liquid crystal display panel in synchronization with the gate signal; and a timing controller generating a plurality of control signals for the LED driving unit, the gate driving unit and the data driving unit.

This in mind, the present invention aims at providing a PWM circuit that can have two different refresh rates and a related PWM signal generation method thereof.

This is achieved by PWM circuits and PWM signal generation methods according to claims 1 and 7. The dependent claims pertain to corresponding further developments and improvements.

As will be seen more clearly from the detailed description following below, a claimed PWM circuit having two different refresh rates is disclosed. The claimed PWM circuit includes a first PWM signal generator and a second PWM signal generator. Wherein the first PWM signal generator and the second PWM signal generator respectively control two different refresh rates in different dimensions of frames generated from a light processing device.

In the following, the invention is further illustrated by way of example, taking reference to the accompanying drawings. Thereof
FIG. 1 is a diagram illustrating a conventional PWM signal,
FIG. 2 is a block diagram illustrating a PWM circuit according to an embodiment of the present invention,
FIG. 3 is a diagram illustrating the frame operation of a PWM circuit according to an embodiment of the present invention,
FIG. 4 is a diagram illustrating the frame operation of a PWM circuit according to an embodiment of the present invention,
FIG. 5 is a diagram illustrating the frame operation of a PWM circuit according to an embodiment of the present invention,
FIG. 6 is a flowchart illustrating the operation of a PWM signal generation method according to an embodiment of the present invention, and
FIG. 7 is a flowchart illustrating the operation of a PWM signal generation method according to another embodiment of the present invention.

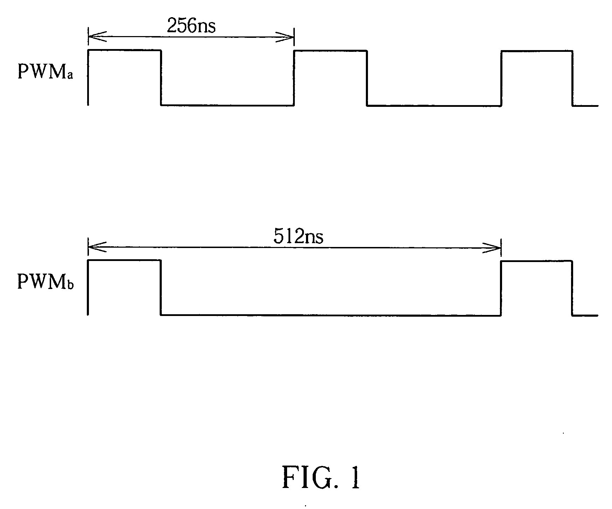

Please refer to FIG. 1, which is a diagram illustrating a conventional PWM signal. PWM signals with different cycles are denoted by PWMₐ and PWM_{b}, respectively. As shown in FIG. 1, an example of a minimum pulse (Ins) is illustrated, where PWMₐ is a PWM signal with a cycle of 256ns, and PWM_{b} is a PWM signal with a cycle of 512ns. When the PWM signal is used to control the brightness of video frames, the cycle means the refresh rate. That is to say, a PWM signal with a short cycle has a higher refresh rate, and a PWM signal with a longer cycle has a lower refresh rate in contrary. In addition, a PWM signal has another important characteristic, the resolution. In the example of FIG. 1, the resolution of the PWMₐ is 1/256, and the resolution of the PWM_{b} is 1/512. That is to say, PWM_{b} could be a control signal with a precision higher than that of PWMₐ. However, as described above, the refresh rate of PWM_{b} is lower than PWMₐ, and thus the resolution is inversely proportional to the refresh rate.

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is electrically connected to another device, that connection may be through a direct electrical connection, or through an indirect electrical connection via other devices and connections.

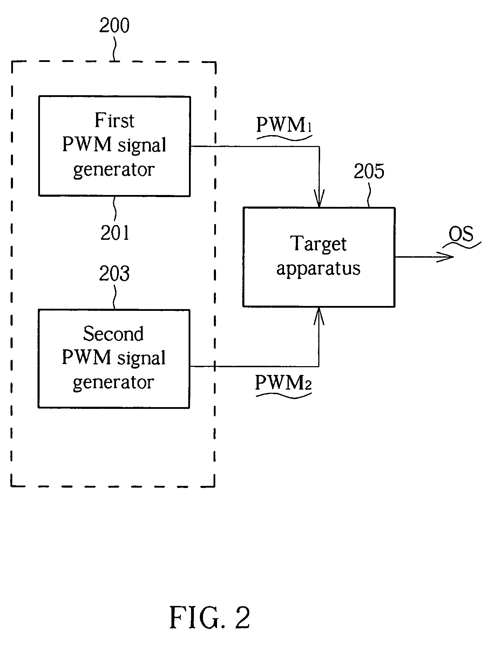

FIG. 2 is a block diagram illustrating a PWM circuit 200 according to an embodiment of the present invention. As shown in FIG. 2, the PWM circuit 200 includes a first PWM signal generator 201 and a second PWM signal generator 203. The first PWM generator 201 and the second PWM generator 203 are used to generate the first PWM signal PWM₁ and the second PWM signal PWM₂ respectively to control refresh rates in different dimensions of the output data OS generated from a target apparatus 205.

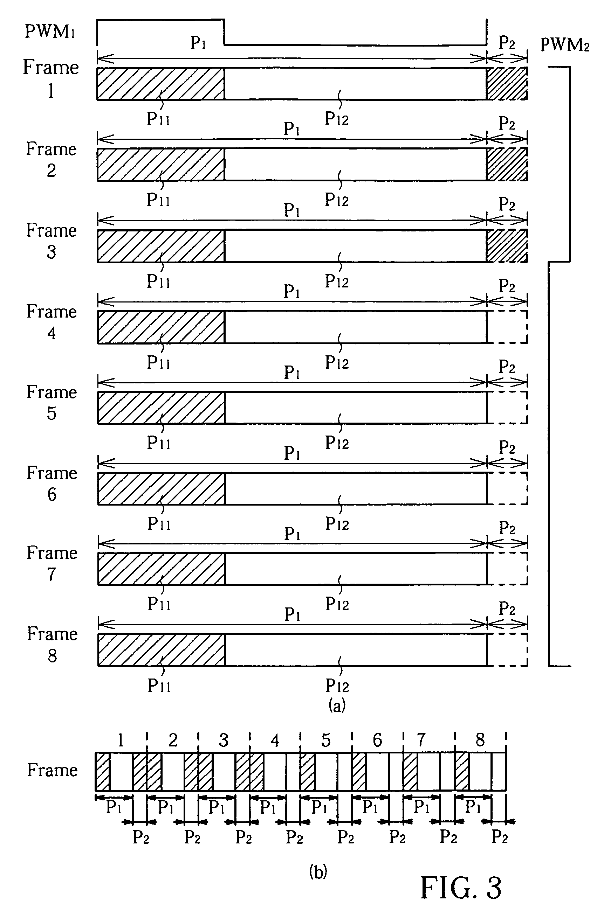

In the following, the operation of the PWM circuit 200 in FIG. 2 is detailed with reference to the diagram in FIG. 3. It should be noted that an image processing device is used as the target apparatus 205 for illustrative purposes. Therefore, the output data OS includes at least a frame, and the first PWM signal generator 201 and the second PWM signal generator 203 are used to control the brightness of the frames in different dimensions, respectively. In this case, the first PWM signal generator 201 and the second PWM signal generator 203 may be regarded as a controller for controlling the brightness of a light processing device, and the light processing device accordingly generates the output data OS with different brightness settings. However, this by no means implies that the concept of the present invention is only allowed to be applied to frames or the aforementioned light processing device. Those skilled in the art should readily understand that the concept of the present invention may be applied to other electronic devices after reading the disclosed embodiments of the present invention.

Please refer to sub-diagram (a) of FIG. 3. As described above, the output data OS includes at least a frame (e.g., frame 1-frame 8 in this embodiment), where each frame could be divided into the first part P₁ and the second part P₂. In this embodiment, the first part P₁ and the second part P₂ represent different bits of the frame. The brightness of the first part P₁ is controlled by the first PWM signal PWM₁, and the brightness of the second part P₂ is controlled by the second PWM signal PWM₂. Please note that the first PWM signal PWM₁ and the second PWM signal PWM₂ control the brightness in different dimensions, respectively. As shown in the sub-diagram (a) of FIG. 3, the changing of the brightness of the first part P₁ is shown on the horizontal direction (the part labeled by slashes is bright), and the changing of the brightness of the first part P₂ is shown on the vertical direction (the part labeled by slashes is bright).

In this embodiment, the single cycle of the single first PWM signal PWM₁ controls at least a portion of each first part P₁, thus each of the first parts P₁ of the frame 1-frame 8 shows the same changing of the brightness. For instance, all of P₁₁ included the first parts P₁ of the frame 1-frame 8 should correspond to the high level of the first PWM signal PWM₁, therefore it shows the bright status. For another example, all of P₁₂ of the first parts P₁ of the frame 1-frame 8 should correspond to the low level of the first PWM signal PWM₁, therefore it shows the dark status. That is to say, the first parts P₁ of the frame 1-frame 8 would correspond to a fist cycle of the first PWM signal PWM₁ and show the same brightness changes.

However, the second PWM signal PWM₂ with a single cycle controls a plurality of second parts P₂. For instance, some frames, including frame 1-frame 3, correspond to the high level of the second PWM signal PWM₂, and the second part P₂ is therefore bright; and other frames, including frame 4-frame 8, correspond to the low level of the second PWM signal PWM₂, and the second part P₂ is therefore dark. That is, the changes composed of the second parts P₂ of the frame 1-frame 8 correspond to a second cycle of the second PWM signal P₂.

In the above-mentioned mechanism, the user would see frames like that presented in sub-diagram (b) of FIG. 3. Hence, the frames viewed by the user are still continuous frame 1-frame 8. However, theses continuous frames are actually controlled by two distinct PWM signals instead of only one PWM signal employed in the conventional technique. Therefore, the PWM circuit 200 is allowed to have two different refresh rates under such a mechanism, which provides more flexibility in the circuit design and breaks the trade off between resolution and refresh rate encountered in the conventional design.

Please note that the above-mentioned embodiment uses two dimensions (i.e., the vertical and the horizontal directions) to illustrate the concept of the present invention. However, the definition of the directions might be changed for different memory arrangements, different data structures, or different drawing presentation manners. Thus, the concept of the present invention should be briefly summarized as using PWM signals in two different dimensions to control the same output data to make the output data normally outputted and have two different refresh rates.

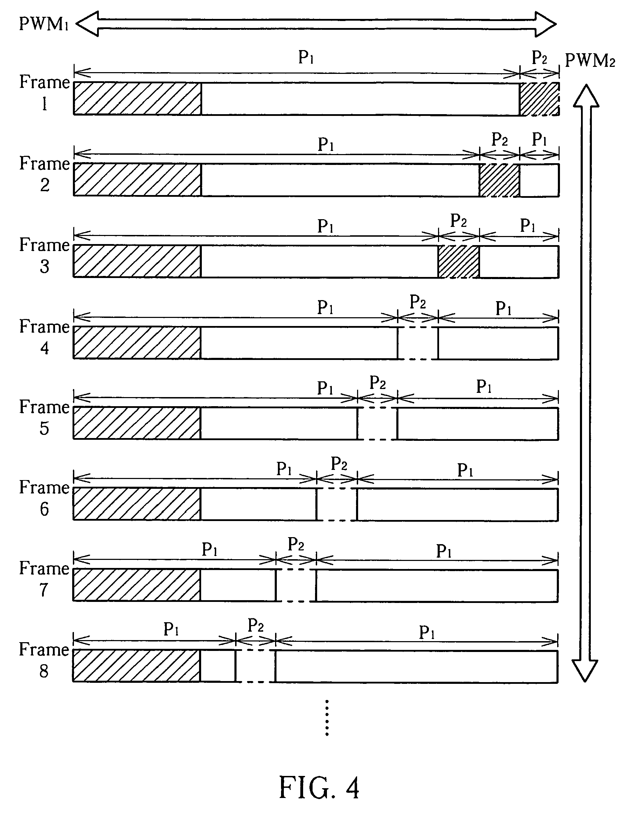

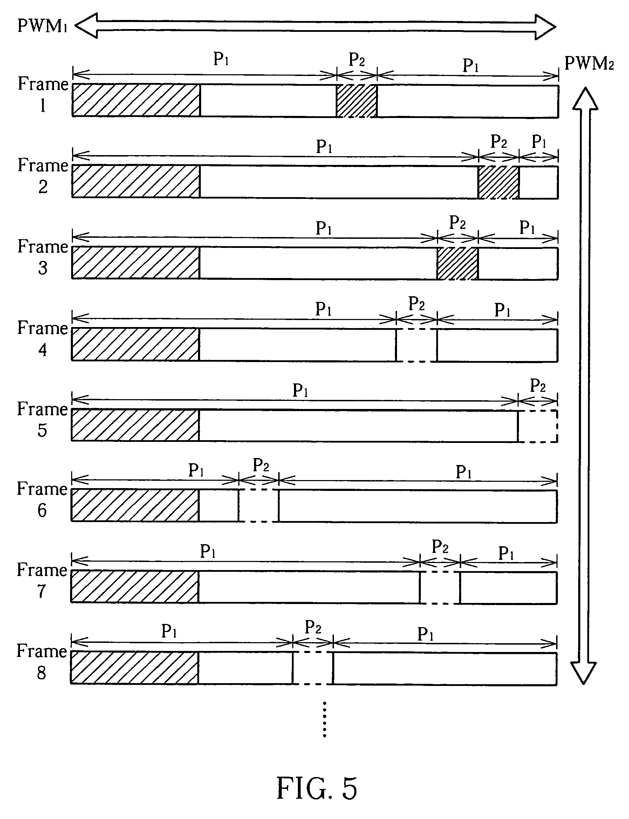

Please note that the second part P₂ in the embodiment shown in FIG. 3 is not limited to the last few bits of each frame. Alternatively, it could be distributed in any positions co-located in all frames. Moreover, the second part P₂ of each frame may meet a specific rule. For example, each of the second parts P2 in FIG. 4 are located at the neighboring position of the previous frame or the next frame. As these specific rules may be modified according to different design requirements, further details are omitted here for brevity. In addition, the position of the second part P₂ may also be decided randomly, as shown in FIG. 5. This also falls within the scope of the present invention.

Regarding the embodiments in FIG. 4 and FIG. 5, the first PWM signal PWM₁ and the second PWM signal PWM₂ may be slightly different from that used in the embodiment of FIG. 3. For example, in the embodiment of FIG. 3, the first PWM signal PWM₁ and the second PWM signal PWM₂ may operate independently without interfering with each other; however, in the embodiments of FIG. 4 and FIG. 5, the timing issue of the first PWM signal PWM₁ and the second PWM signal PWM₂ should be considered. Taking the embodiment of FIG. 4 for example, due to that the position of the second part P₂ of the frame 1 and the position of the second part P₂ of the frame 2 are different, the position of the second part P₂ of the frame 2 was controlled by the first PWM signal PWM₁ in frame 1, but would be controlled by the second PWM signal PMW₂ in frame 2.

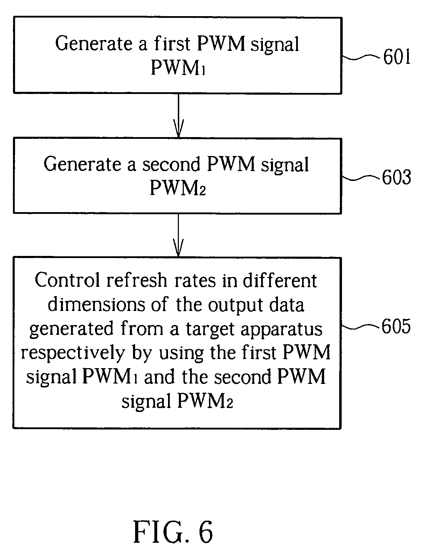

According to the above embodiments, the PWM signal generation method as shown in FIG. 6 is obtained and includes:
Step 601: Generate a first PWM signal PWM₁;
Step 603: Generate a second PWM signal PWM₂; and
Step 605: Control refresh rates in different dimensions of the frames generated from a target apparatus respectively by using the first PWM signal PWM₁ and the second PWM signal PWM₂. Taking the embodiment of FIG. 3 for example, the first PWM signal PWM₁ is used to control the refresh rate in the horizontal direction, while the second PWM signal PWM₂ is used to control the refresh rate in the vertical direction.

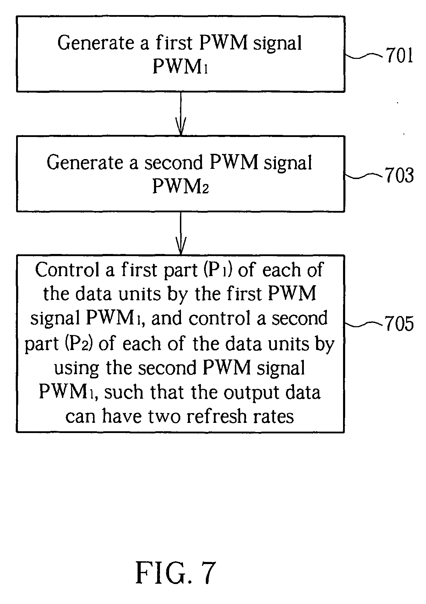

The above-mentioned exemplary PWM signal generation method may be simplified as another WPM signal generation method shown FIG. 7, which includes:
Step 701: Generate a first PWM signal PWM₁;
Step 703: Generate a second PWM signal PWM₂; and
Step 705: Control a first part (P₁) of each of the data units (e.g., frame 1-frame 8 of FIG. 3) by the first PWM signal PWM₁, and control a second part (P₂) of each of the data units by using the second PWM signal PWM₁, such that the output data can have two refresh rates.

As those skilled in this art can readily understand operations of the PWM signal generation methods of FIG. 6 and FIG. 7 after reading aforementioned embodiment of the present invention, further details are omitted here for brevity.

The above-mentioned embodiments could provide a PWM circuit and a PWM signal generation method that can have two fresh rates. With the use of the proposed mechanism, the problem of the resolution significantly limited due to the single refresh rate in the conventional design would be avoided.

## Claims

1. A pulse width modulation, hereinafter PWM, circuit (200) having two refresh rates, comprising:
a first PWM signal generator (201); and
a second PWM signal generator (203);
wherein the first PWM signal generator (201) generates a first PWM signal and the second PWM signal generator (203) generates a second PWM signal to control different refresh rates in different dimensions of frames generated from a light processing device (205), respectively,
**characterized in that**
the first PWM signal generator (201) controls a first part of each of the frames, and the second PWM signal generator (203) controls a second part of each of the frames, such that the frames have two different refresh rates.

2. The PWM circuit (200) of claim 1, **characterized in that** the first PWM signal generator (201) and the second PWM signal generator (203) are arranged to control brightness of the frames in the different dimensions, respectively.

3. The PWM circuit (200) of claim 1, **characterized in that** the second part is located in a same position in each of the frames.

4. The PWM circuit (200) of claim 1, **characterized in that** a position of the second part of each of the frames meets a specific corresponding rule.

5. The PWM circuit (200) of claim 1, **characterized in that** a position of the second part of each of the framesis decided randomly.

6. The PWM circuit (200) of claim 1, **characterized in that** the first PWM signal generator (201) generates a first PWM signal; the second PWM signal generator (203) generates a second PWM signal; a plurality of first parts of the frames correspond to a first cycle of the first PWM signal and show a same change; and a plurality of second parts of the frames correspond to a second cycle of the second PWM signal and show a same change.

7. A pulse width modulation, hereinafter PWM, signal generation method having two refresh rates, comprising:
generating a first PWM signal;
generating a second PWM signal; and
controlling different refresh rates in different dimensions of a plurality of frames generated from a light processing device (205) respectively by using the first PWM signal and the second PWM signal,
**characterized by**:
controlling a first part of each of the frames by the first PWM signal, and controlling a second part of each of the frames by using the second PWM signal, such that the frames have two different refresh rates.

8. The PWM signal generation method of claim 7, characterized the first PWM signal and the second PWM signal are arranged to control brightness of the frames in the different dimensions, respectively.

9. The PWM signal generation method of claim 7, **characterized in that** the second part is located in a same position of each of the frames.

10. The PWM signal generation method of claim 7, **characterized in that** a position of the second part of each of the frames meets a specific corresponding rule, or a position of the second part of each of the frames meets a specific corresponding rule is decided randomly.

11. The PWM signal generation method of claim 7, **characterized in that** a plurality of first parts of the frames correspond to a first cycle of the first PWM signal and show a same change; and a plurality of second parts of the frames correspond to a second cycle of the second PWM signal and show a same change.

## Patentansprüche

1. Pulsbreitenmodulation-, nachfolgend PWM bezeichnet, Schaltung (200), die zwei Wiederholraten aufweist, umfassend:
einen ersten PWM-Signalgenerator (201); und
einen zweiten PWM-Signalgenerator (203);
wobei der erste PWM-Signalgenerator (201) ein erstes PWM-Signal erzeugt und der zweite PWM-Signalgenerator (203) ein zweites PWM-Signal erzeugt, um jeweils unterschiedliche Wiederholraten in unterschiedlichen Dimensionen von Frames zu steuern, die von einer Lichtverarbeitungsvorrichtung (205) erzeugt wurden,
**dadurch gekennzeichnet, dass**
der erste PWM-Signalgenerator (201) einen ersten Teil eines jeden der Frames steuert, und der zweite PWM-Signalgenerator (203) einen zweiten Teil eines jeden der Frames steuert, sodass die Frames zwei unterschiedliche Wiederholraten aufweisen.

2. PWM-Schaltung (200) nach Anspruch 1, **dadurch gekennzeichnet, dass** der erste PWM-Signalgenerator (201) und der zweite PWM-Signalgenerator (203) jeweils zum Steuern einer Helligkeit der Frames in den unterschiedlichen Dimensionen eingerichtet sind.

3. PWM-Schaltung (200) nach Anspruch 1, **dadurch gekennzeichnet, dass** der zweite Teil in jedem der Frames an einer gleichen Position angeordnet ist.

4. PWM-Schaltung (200) nach Anspruch 1, **dadurch gekennzeichnet, dass** eine Position des zweiten Teils eines jeden der Frames eine spezifische entsprechende Regel erfüllt.

5. PWM-Schaltung (200) nach Anspruch 1, **dadurch gekennzeichnet, dass** eine Position des zweiten Teils eines jeden der Frames zufällig bestimmt ist.

6. PWM-Schaltung (200) nach Anspruch 1, **dadurch gekennzeichnet, dass** der erste PWM-Signalgenerator (201) ein erstes PWM-Signal erzeugt; der zweite PWM-Signalgenerator (203) ein zweites PWM-Signal erzeugt; eine Vielzahl von ersten Teilen der Frames zu einem ersten Zyklus des ersten PWM-Signals korrespondieren und eine gleiche Änderung aufweisen; und eine Vielzahl von zweiten Teilen der Frames zu einem zweiten Zyklus des zweiten PWM-Signals korrespondieren und eine gleiche Änderung aufweisen.

7. Pulsweitenmodulation-, nachfolgend PWM bezeichnet, Signalerzeugungsverfahren, das zwei Wiederholraten aufweist, umfassend:
Erzeugen eines ersten PWM-Signals;
Erzeugen eines zweiten PWM-Signals; und
jeweiliges Steuern von unterschiedlichen Wiederholraten in unterschiedlichen Dimensionen einer Vielzahl von Frames, die von einer Lichtverarbeitungsvorrichtung (205) unter Verwendung des ersten PWM-Signals und des zweiten PWM-Signals erzeugt werden,
**gekennzeichnet durch**:
Steuern eines ersten Teils eines jeden der Frames **durch** das erste PWM-Signal, und Steuern eines zweiten Teils eines jeden der Frames unter Verwendung des zweiten PWM-Signals, sodass die Frames zwei unterschiedliche Wiederholraten aufweisen.

8. PWM-Signalerzeugungsverfahren nach Anspruch 7, **dadurch gekennzeichnet, dass** das erste PWM-Signal und das zweite PWM-Signal zum Steuern einer Helligkeit der Frames in den unterschiedlichen Dimensionen eingerichtet sind.

9. PWM-Signalerzeugungsverfahren nach Anspruch 7, **dadurch gekennzeichnet, dass** der zweite Teil an einer gleichen Position eines jeden der Frames angeordnet ist.

10. PWM-Signalerzeugungsverfahren nach Anspruch 7, **dadurch gekennzeichnet, dass** eine Position des zweiten Teils eines jeden der Frames eine spezifische entsprechende Regel erfüllt, oder eine Position des zweiten Teils eines jeden der Frames eine spezifische entsprechende Regel erfüllt, die zufällig bestimmt wird.

11. PWM-Signalerzeugungsverfahren nach Anspruch 7, **dadurch gekennzeichnet, dass** eine Vielzahl von ersten Teilen der Frames einem ersten Zyklus des ersten PWM-Signals entsprechen und eine gleiche Änderung aufweisen; und eine Vielzahl von zweiten Teilen der Frames einem zweiten Zyklus des zweiten PWM-Signals entsprechen und eine gleiche Änderung aufweisen.

## Revendications

1. Circuit (200) de modulation de largeur d'impulsion, ci-après PWM, ayant deux taux de rafraîchissement, comprenant :
un premier générateur de signal PWM (201); et
un deuxième générateur de signal PWM (203) ;
dans lequel le premier générateur de signal PWM (201) génère un premier signal PWM et le deuxième générateur de signal PWM (203) génère un deuxième signal PWM pour commander des taux de rafraîchissement différents dans différentes dimensions de trames générées à partir d'un dispositif de traitement de lumière (205), respectivement,
**caractérisé en ce que**
le premier générateur de signal PWM (201) commande une première partie de chacune des trames, et le deuxième générateur de signal PWM (203) commande une deuxième partie de chacune des trames, de sorte que les trames aient deux taux de rafraîchissement différents.

2. Circuit PWM (200) de la revendication 1, **caractérisé en ce que** le premier générateur de signal PWM (201) et le deuxième générateur de signal PWM (203) sont agencés pour commander une luminosité des trames dans les différentes dimensions, respectivement.

3. Circuit PWM (200) de la revendication 1, **caractérisé en ce que** la deuxième partie est située dans la même position dans chacune des trames.

4. Circuit PWM (200) de la revendication 1, **caractérisé en ce qu'**une position de la deuxième partie de chacune des trames répond à une règle correspondante spécifique.

5. Circuit PWM (200) de la revendication 1, **caractérisé en ce qu'**une position de la deuxième partie de chacun des trames est choisie aléatoirement.

6. Circuit PWM (200) de la revendication 1, **caractérisé en ce que** le premier générateur de signal PWM (201) génère un premier signal PWM ; le deuxième générateur de signal PWM (203) génère un deuxième signal PWM ; une pluralité de premières parties des trames correspondent à un premier cycle du premier signal PWM et présentent le même changement ; et une pluralité de deuxièmes parties des trames correspondent à un deuxième cycle du deuxième signal PWM et présentent le même changement.

7. Procédé de génération de signal de modulation de largeur d'impulsion, ci-après PWM, ayant deux taux de rafraîchissement, comprenant le fait :
de générer un premier signal PWM ;
de générer un deuxième signal PWM ; et
de commander des taux de rafraîchissement différents dans différentes dimensions d'une pluralité de trames générées à partir d'un dispositif de traitement de lumière (205), respectivement, en utilisant le premier signal PWM et le deuxième signal PWM,
**caractérisé par** le fait :
de commander une première partie de chacune des trames par le premier signal PWM, et de commander une deuxième partie de chacune des trames en utilisant le deuxième signal PWM, de sorte que les trames aient deux taux de rafraîchissement différents.

8. Procédé de génération de signal PWM de la revendication 7, **caractérisé en ce que** le premier signal PWM et le deuxième signal PWM sont agencés pour commander une luminosité des trames dans les différentes dimensions, respectivement.

9. Procédé de génération de signal PWM de la revendication 7, **caractérisé en ce que** la deuxième partie est située dans la même position de chacune des trames.

10. Procédé de génération de signal PWM de la revendication 7, **caractérisé en ce qu'**une position de la deuxième partie de chacune des trames répond à une règle correspondante spécifique, ou **en ce qu'**une position de la deuxième partie de chacune des trames qui répond à une règle correspondante spécifique est choisie aléatoirement.

11. Procédé de génération de signal PWM de la revendication 7, **caractérisé en ce qu'**une pluralité de premières parties des trames correspondent à un premier cycle du premier signal PWM et présentent le même changement ; et une pluralité de deuxièmes parties des trames correspondent à un deuxième cycle du deuxième signal PWM et présentent le même changement.
